# FASCICULE DE BREVET EUROPEEN

(11) **EP 2 458 621 B1**
(45) Date de publication et mention de la délivrance du brevet: **25.02.2015**
(21) Numéro de dépôt: 11354071.0
(22) Date de dépôt: 29.11.2011
(51) Int. Cl.: H01L 21/033

(54) **Procédé de réalisation amélioré d'un motif à partir du transfert par espaceurs latéraux**
Verfahren zur verbesserten Ausführung eines Motivs aus der Übertragung über seitliche Abstandhalter
Improved method for making a pattern based on transfer by lateral spacers

(30) Priorité: 30.11.2010 FR 1004655
(43) Date de publication de la demande: 30.05.2012
(73) Titulaire: Commissariat à l'Énergie Atomique et aux Énergies Alternatives, 75015 Paris (FR)
(72) Inventeur: Barnola, Sébastien, 38190 Villard-Bonnot (FR); Belledent, Jérôme, 38240 Meylan (FR)
(74) Mandataire: Talbot, Alexandre

(56) Documents cités:
- US-A1- 2006 046 422
- US-A1- 2010 291 771

## Description

### Domaine technique de l'invention

L'invention est relative à un procédé de réalisation d'un motif en premier matériau.

### État de la technique

L'augmentation continue des performances des circuits intégrés, par exemple, en termes de consommation et/ou de fréquence de fonctionnement, se traduit inéluctablement par une diminution constante de la taille de ses composants et un accroissement de leur densité. Afin de réaliser des dispositifs toujours plus performants, de nouvelles techniques de définitions de motifs de petites tailles ont été mises en place.

La diminution des dimensions du transistor se traduit surtout par des difficultés dans la définition en grande densité des motifs de petites dimensions, mais aussi par une augmentation des contraintes liées à l'alignement des différents niveaux photolithographiques les uns par rapport aux autres. Afin de former des motifs toujours plus denses, les équipements de photolithographie et de gravure doivent être améliorés en permanence. Cette augmentation croissante des contraintes technologiques sur les équipements de photolithographie n'est plus compatible avec les équipements actuels.

Une voie alternative de développement consiste à définir la largeur et/ou la longueur du motif désiré au moyen d'une étape de dépôt d'un matériau de masquage. De cette manière, au moins une des dimensions latérales du motif n'est pas définie par photolithographie, mais au moyen du dépôt d'une épaisseur prédéfinie de matériau de masquage.

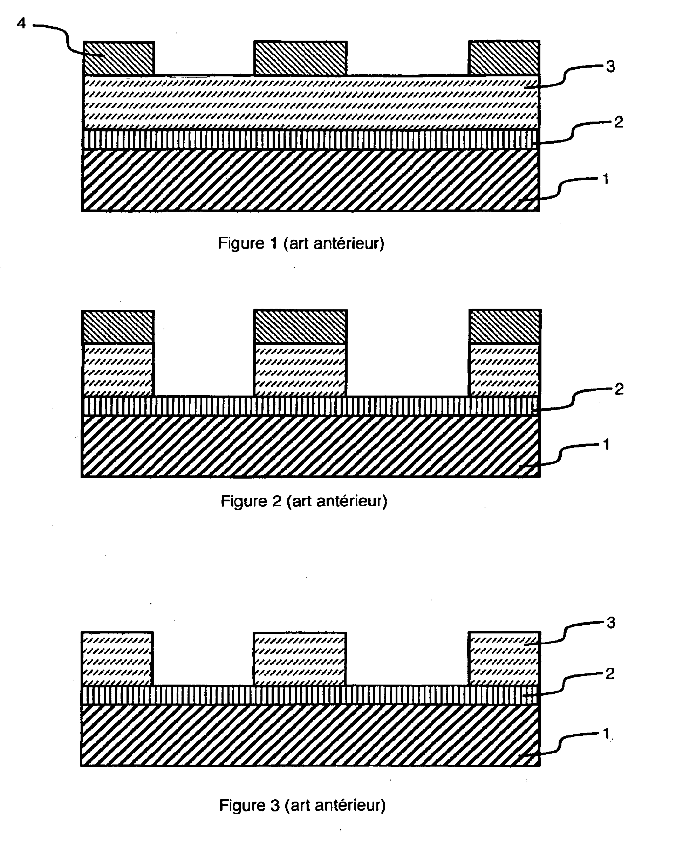

Comme illustré à la figure 1, un substrat 1 est recouvert par une couche en premier matériau 2, elle-même recouverte par une couche de recouvrement 3. Un masque de gravure 4 est formé, par toute technique adaptée, sur la couche de recouvrement 3.

Comme illustré à la figure 2, la couche de recouvrement 3 est gravée, par exemple par plasma, à travers le masque de gravure 4 afin de reproduire dans cette dernière le dessin du masque de gravure 4.

La chimie de gravure est choisie sélective par rapport au masque de gravure et par rapport au premier matériau 2 afin d'éliminer une partie de la couche de recouvrement 3 sans abîmer le premier matériau 2, ni modifier le dessin du masque de gravure 4.

Une perte de sélectivité vis-à-vis du premier matériau 2 entraîne notamment une dégradation des propriétés physico-chimiques et une diminution de l'épaisseur de premier matériau ce qui est préjudiciable au bon accomplissement des étapes ultérieures.

La chimie de gravure est choisie la plus anisotrope possible afin de reproduire fidèlement le dessin du masque de gravure 4 dans la couche de recouvrement 3.

Cette étape de gravure forme un motif en matériau de recouvrement 3 défini à partir du dessin du masque de gravure 4.

Comme illustré à la figure 3, une fois la couche de recouvrement 3 structurée, le premier masque de gravure 4 est éliminé.

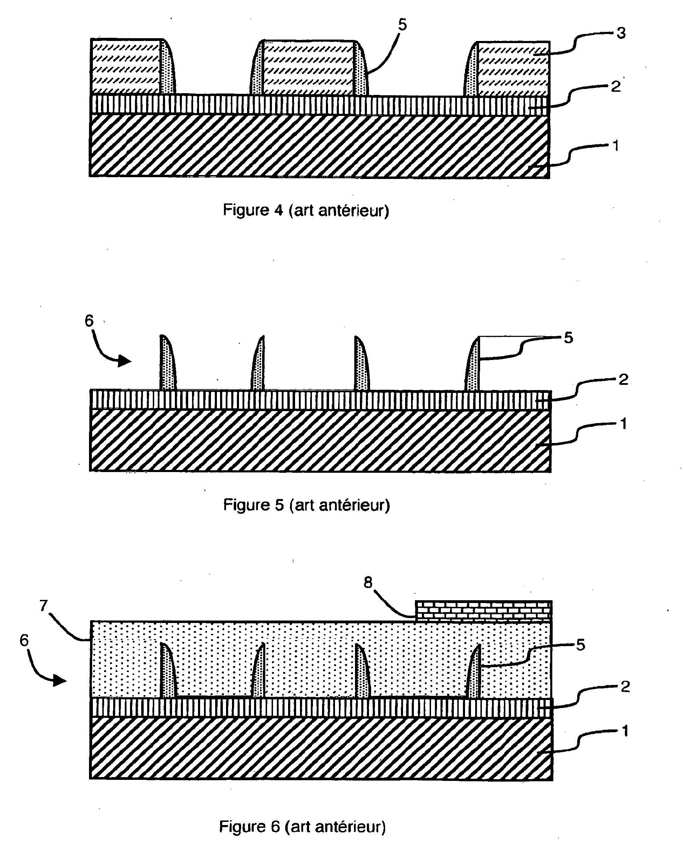

Comme illustré à la figure 4, un matériau de masquage 5 est déposé puis gravé afin de former un ou plusieurs espaceurs latéraux. Le matériau de masquage 5 est déposé de manière conforme et il est gravé anisotropiquement afin de le localiser sur les parois latérales du motif en matériau de recouvrement 3.

L'épaisseur de matériau déposé définit une des dimensions du motif en matériau de masquage 5. Cette dimension est réduite lors de l'étape de gravure plasma. De cette manière, l'étape de photolithographie définit la position des motifs et l'étape de formation des espaceurs latéraux définit au moins une des dimensions latérales de ces motifs.

Là encore, la gravure du matériau de masquage 5 utilise une chimie qui est fortement anisotrope et sélective par rapport au premier matériau 2 et au matériau de recouvrement 3.

Comme illustré à la figure 5, une fois que les espaceurs latéraux sont formés, le matériau de recouvrement 3 est éliminé et les espaceurs forment un deuxième masque de gravure 6.

Comme cela est illustré à la figure 6, le deuxième masque de gravure 6, obtenu par la technique de transfert d'espaceurs latéraux, est recouvert par un second matériau de recouvrement 7. Un troisième masque de gravure 8 est formé sur le deuxième matériau de recouvrement 7.

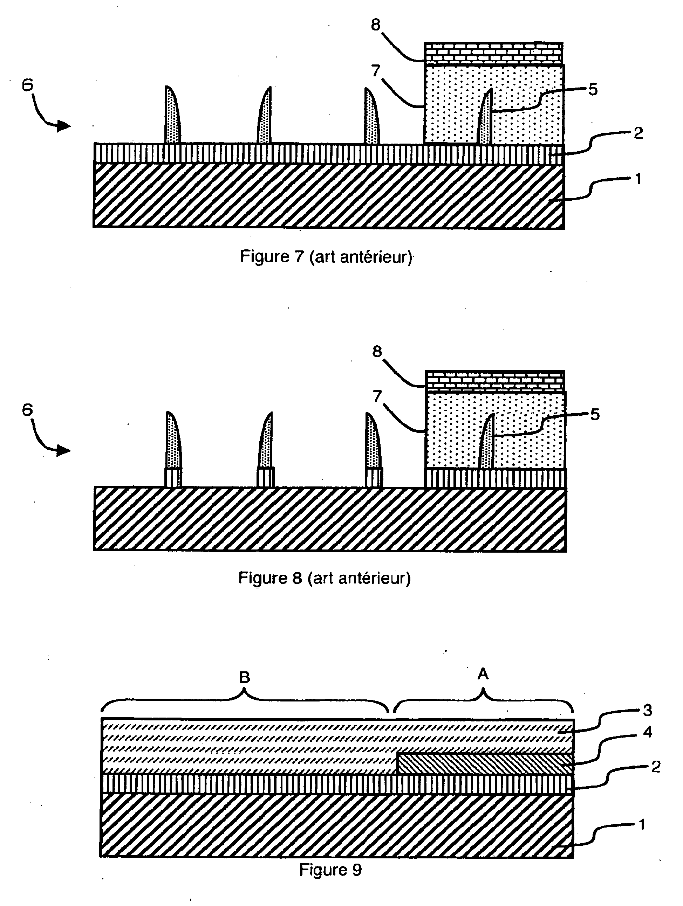

Comme illustré à la figure 7, le deuxième matériau de recouvrement 7 est gravé au moyen du troisième masque de gravure 8 jusqu'à atteindre le deuxième masque de gravure 6 et le premier matériau 2.

Le premier matériau 2 est ensuite gravé au moyen du deuxième masque de gravure 6 (les espaceurs en matériau de masquage 5) et du troisième masque de gravure 8 comme cela est illustré à la figure 8 pour former un motif en premier matériau. Le dessin du motif en premier matériau 2 correspond à la combinaison des dessins du deuxième masque de gravure 6 et du troisième masque de gravure 8.

Ce procédé de mise en oeuvre, dont un exemple est décrit dans US 2006-046422, est très difficile à utiliser car il est associé à un grand nombre de contraintes technologiques qui sont réparties dans les différentes étapes du procédé.

### Objet de l'invention

On constate qu'il existe un besoin de prévoir un procédé de réalisation d'un motif partiellement défini par transfert d'espaceurs latéraux qui soit plus simple de mise en oeuvre.

On tend à satisfaire ce besoin au moyen d'un procédé selon les revendications annexées et plus particulière au moyen d'un procédé qui comporte les étapes suivantes :
- prévoir un substrat muni d'une couche en premier matériau recouverte par un premier masque de gravure, une couche de recouvrement débordant du premier masque de gravure et un deuxième masque de gravure, la couche de recouvrement ayant une zone principale recouverte par le deuxième masque de gravure et une zone secondaire découverte,
- graver partiellement la zone secondaire de la couche de recouvrement au moyen du deuxième masque de gravure de manière à former un motif en saillie dans la couche de recouvrement,
- déposer et graver un matériau de masquage de manière à former des espaceurs latéraux autour du motif en saillie définissant un troisième masque de gravure,
- éliminer le deuxième masque de gravure,
- graver la couche de recouvrement au moyen du troisième masque de gravure de manière à former un motif en saillie dans la couche de recouvrement et découvrir le premier masque de gravure et le premier matériau,
- graver la couche en premier matériau au moyen de la couche de recouvrement et du premier masque de gravure pour former le motif en premier matériau.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- les figures 1 à 8 représentent, de manière schématique, en vue de coupe des étapes successives de mise en oeuvre d'un premier procédé,
- les figures 9 à 16 représentent, de manière schématique, en vue de coupe des étapes successives de mise en oeuvre d'un deuxième procédé,
- la figure 17 représente, de manière schématique, en vue de coupe une variante de réalisation en relation avec la figure 12,
- la figure 18 représente, de manière schématique, une vue en coupe d'une autre variante de réalisation.

### Description de modes de réalisation préférentiels de l'invention

Comme illustré à la figure 9, un substrat 1 comporte un support qui est recouvert par une couche en premier matériau 2. La couche en premier matériau 2 est recouverte par un premier masque de gravure 4 et une couche de recouvrement 3.

Le support est, par exemple, un substrat en matériau semi-conducteur avec des composants actifs recouverts par une ou plusieurs couches de protection. Le support peut également être formé par un matériau électriquement conducteur ou électriquement isolant à la surface duquel des motifs sont à former. De manière avantageuse, la face principale du support est formée par une ou plusieurs couches en matériau électriquement isolant. La face principale du support est recouverte par la couche en premier matériau 2.

Le premier matériau 2 peut être isolant ou conducteur électriquement. De manière avantageuse, si le substrat est de type semi-conducteur avec des couches isolantes sur sa surface principale, le premier matériau est électriquement conducteur, par exemple en TiN, BN, TaN, AIN avec une épaisseur avantageuse comprise entre 10 et 50 nm.

Le premier masque de gravure 4 est formé sur la couche en premier matériau 2. Le premier masque de gravure 4 définit une zone principale A et une zone secondaire B sur le premier matériau 2. La zone principale A est recouverte directement par le premier masque de gravure 4 et la zone secondaire B est recouverte directement par la couche de recouvrement 3. Le dessin du masque de gravure 4 est quelconque, il est défini en fonction des motifs désirés. Le premier masque de gravure 4 est disposé entre la couche en premier matériau 2 et la couche de recouvrement 3 et il empêche le contact direct entre le premier matériau 2 et la couche de recouvrement 3 dans la zone principale A.

Le premier masque de gravure 4 est par exemple un oxyde de silicium, un nitrure de silicium, un mélange ou un empilement de ces derniers. Le premier masque de gravure peut être formé dans un autre matériau tant que la nature de ses constituants est compatible avec sa position entre le premier matériau 2 et la couche de recouvrement 3.

De manière avantageuse, la couche de recouvrement 3 présente des propriétés antireflets afin de faciliter la formation d'un deuxième masque de gravure 6 par la suite. A titre d'exemple, le matériau de recouvrement 3 est un matériau carboné déposé par dépôt chimique en phase vapeur ou par dépôt à la tournette. Par exemple, le matériau utilisé est représenté par la formule CxHy ce qui traduit un matériau de type carbone plus ou moins hydrogéné.

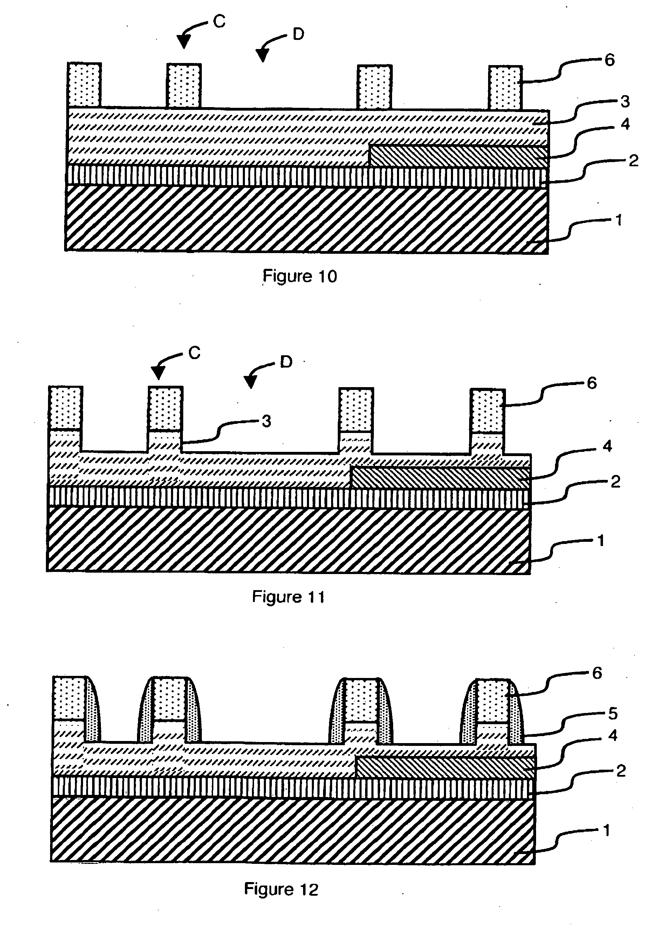

Comme illustré à la figure 10, un deuxième masque de gravure 6 est formé sur la couche de recouvrement 3. Le deuxième masque de gravure 6 définit également une zone principale C et une zone secondaire D sur la couche de recouvrement 3. La zone principale C est recouverte par le deuxième masque de gravure 6 et la zone secondaire D est découverte, elle est donc laissée libre. Le dessin du deuxième masque de gravure 6 est quelconque, il est défini en fonction des motifs désirés, par rapport au dessin du premier masque de gravure 4. Les premier 4 et second 6 masques de gravure sont séparés par la couche de recouvrement 3.

Le deuxième masque de gravure 6 est, par exemple, une résine photosensible ou un matériau de nature différente. Dans certains modes de réalisation, le deuxième masque de gravure 6 est en oxyde de silicium, en nitrure de silicium, un empilement de ces derniers ou un autre matériau. Lorsque le deuxième masque de gravure 6 n'est pas une résine, il est avantageux de définir sa forme au moyen d'une étape de photolithographie suivie d'une étape de gravure. Le deuxième masque de gravure 6 est également appelé masque dur.

Comme cela est illustré à la figure 11, le matériau de recouvrement 3 est gravé, par toute technique adaptée, au moyen du deuxième masque de gravure 6. La gravure de la couche de recouvrement 3 est partielle. La partie du matériau de recouvrement 3 laissée libre est partiellement gravée de manière à former un motif en saillie dans la couche de recouvrement 3. Cette gravure partielle est représentée par des zones d'épaisseurs différentes. Dans la zone principale C recouverte par le deuxième masque de gravure 6, l'épaisseur est inchangée et représente une zone épaisse. Dans la zone secondaire D découverte, la couche de recouvrement 3 a été partiellement éliminée et cela correspond à une zone mince de la couche 3.

Le dessin du deuxième masque de gravure 6 a été reproduit dans la couche de recouvrement 3 à travers le deuxième masque de gravure 6 et le contour du dessin est formé par des parois latérales qui sont verticales ou sensiblement verticales et qui relient la zone mince à la zone épaisse. La gravure de la couche de recouvrement 3 étant réalisée sur une partie seulement de l'épaisseur du matériau de recouvrement, la hauteur de la paroi latérale est inférieure à l'épaisseur de la couche de recouvrement 3.

La couche de recouvrement 3 est donc structurée afin de former des zones avec des épaisseurs différentes ce qui se traduit par la présence de motifs en saillie dans la couche en matériau de recouvrement sur un film continu en matériau de recouvrement 3.

De manière avantageuse, le premier matériau 2 et le premier masque de gravure 4 sont complètement recouverts par la couche de recouvrement 3. De manière avantageuse, la gravure est réalisée par plasma en imposant le temps de gravure ou en contrôlant l'épaisseur de gravure par réflectométrie in-situ.

Comme illustré à la figure 12, un matériau de masquage 5 est ensuite déposé de manière conforme ou le plus conforme possible sur l'ensemble et il recouvre la couche de recouvrement 3 et le deuxième masque de gravure 6. Dans un dépôt conforme, l'épaisseur déposée sur les parois verticales est identique à l'épaisseur déposée sur les parois horizontales. Une fois le matériau de masquage 5 déposé, ce dernier est gravé par toute technique adaptée, de préférence avec une gravure plasma anisotrope, afin de former des espaceurs latéraux. La gravure permet de localiser le matériau de masquage 5 sur les parois verticales définies dans la couche de recouvrement 3. De cette manière, après l'étape de gravure, le matériau de masquage 5 forme des espaceurs latéraux qui recouvrent les parois latérales du matériau de recouvrement 3.

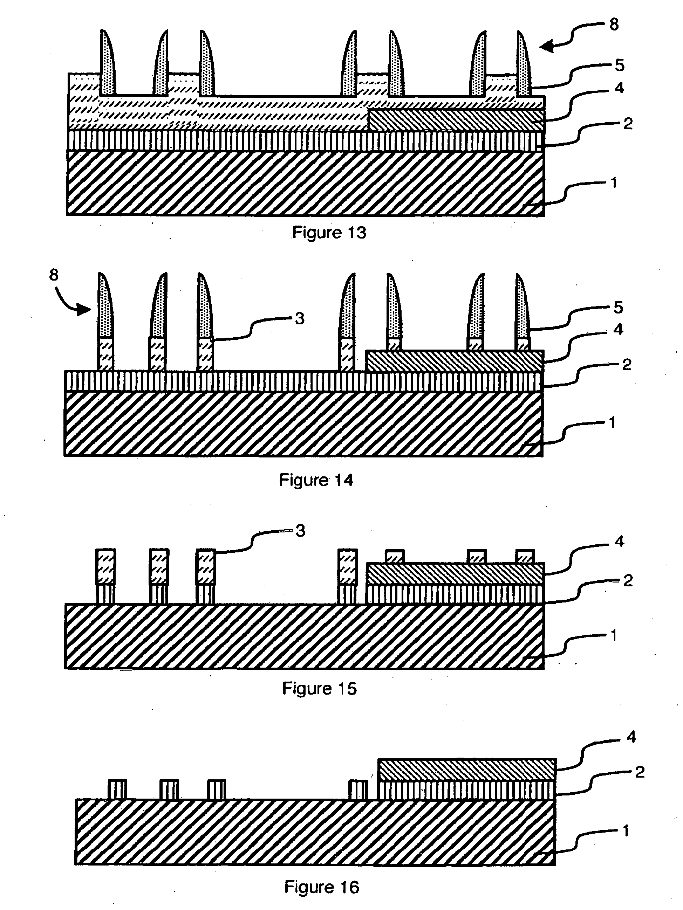

Comme illustré à la figure 13, le second masque de gravure 6 est éliminé afin de laisser à la surface, le matériau de recouvrement 3 et les espaceurs en matériau de masquage 5. Les espaceurs en matériau de masquage 5 forment un troisième masque de gravure 8. Le dessin du troisième masque de gravure 8 est défini en partie par le dessin du deuxième masque de gravure 6 qui impose la position des espaceurs latéraux. Le dessin du troisième masque de gravure 8 est également défini à partir de l'épaisseur de matériau de masquage 5 déposé et de l'épaisseur gravée pour définir les espaceurs latéraux.

Comme cela est illustré à la figure 14, la couche de recouvrement 3 est gravée au moyen du troisième masque de gravure 8 de manière à former un motif en saillie dans la couche de recouvrement 3. Dans les zones découvertes, c'est-à-dire dans les zones non recouverte par le troisième masque de gravure 8, la gravure est totale de manière à atteindre le premier matériau 2 ou le premier masque de gravure 4. Le matériau de recouvrement 3 est éliminé sous les zones initialement recouvertes par le deuxième masque de gravure 6 ainsi que dans la seconde zone D aux endroits non recouverts par les espaceurs latéraux.

Les motifs en matériau de recouvrement 3 sont formés dans la zone mince, leur épaisseur a été définie lors de la gravure partielle du matériau de recouvrement 3. Les motifs en matériau de recouvrement 3 reproduisent le dessin du troisième masque de gravure 8.

Ce mode de mise en oeuvre est particulièrement avantageux car il offre une plus grande souplesse dans la définition du troisième masque de gravure 8. Un dépôt n'est jamais parfaitement conforme et une gravure n'est jamais parfaitement anisotrope. Il en ressort que, dans l'art antérieur, la forme des espaceurs latéraux est limitée par les possibilités technologiques des équipements ou par les contraintes en épaisseurs minimales imposées par d'autres étapes technologiques. Dans l'art antérieur, l'épaisseur de la couche de recouvrement donne la hauteur des espaceurs latéraux.

Dans le cas présent, la différence d'épaisseur entre la zone mince et la zone épaisse et l'épaisseur du deuxième masque de gravure 6 impose la hauteur des espaceurs latéraux. Il est alors possible de moduler la profondeur d'enfoncement dans le matériau de recouvrement 3 afin d'obtenir un dépôt du matériau de masquage 5 qui permette d'obtenir un dépôt conforme ou le plus conforme possible. De manière analogue, cette souplesse dans la hauteur des espaceurs latéraux permet d'obtenir des procédés de gravure plus performants. La réalisation de la gravure partielle du matériau de recouvrement 3 permet l'obtention de degrés de libertés supplémentaires dans la réalisation des espaceurs latéraux à la forme désirée. L'épaisseur du matériau de recouvrement 3 peut ainsi être choisie indépendamment pour minimiser la réflectivité lors de la lithographie.

La réalisation d'une gravure partielle de la couche de recouvrement 3 laisse le premier matériau 2 et le premier masque de gravure 4 recouvert par la couche de recouvrement 3 formant une surface plane libre. Ceci permet également d'éviter la formation de motifs parasites dans le troisième masque de gravure 8. Un résultat identique est obtenu en gravant complètement la couche de recouvrement 3 au-dessus du premier masque de gravure 4 et en s'assurant que la surface libre du premier masque de gravure 4 et de la couche de recouvrement 3 adjacente forment une surface plane dans les zones découvertes.

Comme le premier masque de gravure 4 est recouvert par le matériau de recouvrement 3, il n'existe pas de marche parasite entre le premier masque de gravure 4 et le premier matériau 2. De ce fait, des espaceurs latéraux parasites ne sont pas formés au niveau de cette marche.

La gravure partielle du matériau de recouvrement 3 permet de gommer les inégalités de surface présentes avant le dépôt du matériau de recouvrement, par exemple, une topographie de surface sur le substrat 1 et/ou sur la couche en premier matériau 2 ainsi que la topographie de surface entre le premier matériau 2 et le premier masque de gravure 4.

L'épaisseur de la couche de recouvrement 3 est choisie de manière à limiter l'effet des couches et des motifs inférieures lors de l'étape de définition du second masque de gravure 6. Il est alors possible d'utiliser une couche de recouvrement 3 assez épaisse pour masquer l'effet des couches inférieures. L'épaisseur de la couche de recouvrement 3 n'est plus une contrainte car elle est gravée en deux fois. La première gravure partielle permet de définir le troisième masque de gravure 7 dans les meilleures conditions. La seconde gravure complète permet de définir le masque final à utiliser pour graver le premier matériau 2.

De plus, lorsque le premier masque de gravure 4 est réalisé de manière classique, c'est-à-dire par une technique autre que par transfert d'espaceurs latéraux, il est possible d'obtenir des motifs ayant une largeur importante. Il est alors aisé d'aligner le second masque de gravure 6 par rapport au premier masque de gravure. Dans l'art antérieur, le premier masque de gravure 4 est obtenu avec la technique de transfert d'espaceurs latéraux ce qui impose des motifs de petite taille qui rendent difficile l'alignement des niveaux photolithographiques suivants. De plus, le deuxième masque de gravure qui définit les dimensions les plus critiques est réalisé sur une forte topologie, ce qui nécessite l'emploi de matériau aplanissant. Cette forte topologie induit des disparités de réflectivité pour la lithographie qui nuisent à l'obtention de la résolution recherchée. Cette topologie induit également des différences locales de températures, fonction de la densité des motifs sous-jacents, qui modifient les dimensions des motifs au final. Par ailleurs, les motifs transférés dans le deuxième matériau de recouvrement 7 (figure 7) ont un facteur de forme (rapport entre la largeur et la hauteur) élevé, ce qui entraîne des problèmes de tenue mécanique pour ces motifs.

Au contraire dans le procédé décrit, le premier masque de gravure 4 qui définit les dimensions les plus critiques est réalisé sur une surface sans topologie et présente une épaisseur plus faible que le masque de gravure formé par la technique de transfert d'espaceurs latéraux. Ainsi, l'effet du premier masque de gravure 4 sur la définition du deuxième masque de gravure 6 est réduit.

Comme illustré à la figure 15, le premier masque de gravure 4 et le motif formé dans la couche de recouvrement forment un quatrième masque de gravure qui sert à graver le premier matériau 2. Le dessin du quatrième masque de gravure correspond à l'addition des zones pleines du premier masque de gravure 4 et du troisième masque de gravure 8. Des différences peuvent exister si la gravure du matériau de recouvrement comporte une composante isotrope ou si une étape de rétrécissement (trimming) diminue la taille des motifs ou fait disparaître les plus petits motifs.

Comme illustré à la figure 16, le motif en premier matériau 2 est formé à travers le quatrième masque de gravure et donc à travers le premier masque de gravure 4 et le motif en matériau de recouvrement 3.

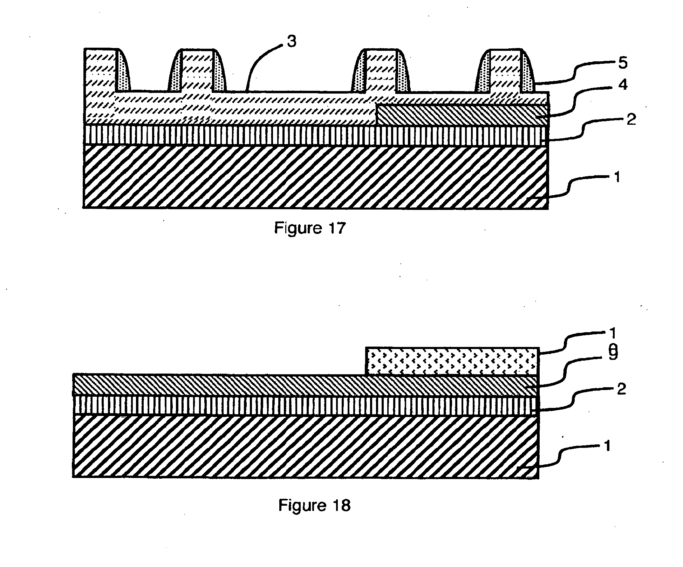

Dans une variante de réalisation illustrée à la figure 17, le deuxième masque de gravure 6 est éliminé avant de déposer le matériau de masquage 5 et de former les espaceurs latéraux. La hauteur des espaceurs latéraux est définie à partir de l'enfoncement dans le matériau de recouvrement 3 ce qui laisse les mêmes marges de manoeuvre que dans le mode de réalisation précédent. Cette variante est particulièrement avantageuse car elle ne nécessite qu'une sélectivité de gravure entre le matériau du deuxième masque de gravure 6 et le matériau de recouvrement 3, ce qui relâche les contraintes dans le choix des matériaux.

Si le deuxième masque de gravure 6 est éliminé après la réalisation des espaceurs latéraux, il faut assurer une sélectivité de gravure non seulement entre le matériau du deuxième masque de gravure 6 et le matériau de recouvrement 3, mais aussi entre le matériau du deuxième masque de gravure 6 et le matériau de masquage 5.

Les espaceurs latéraux formant le troisième masque de gravure 8 sont formés de la même manière que précédemment et le troisième masque de gravure 8 est utilisé comme précédemment pour graver le matériau de recouvrement 3. La structure finale est identique à celle illustrée à la figure 16 du mode de réalisation précédent.

De cette manière, la gravure du matériau de recouvrement 3 est réalisée au moyen d'une gravure sélective du matériau de recouvrement 3 par rapport au troisième masque de gravure 8. Ensuite, le troisième masque de gravure 8 est éliminé sélectivement par rapport au matériau de recouvrement 3. Ensuite, le matériau de masquage 5 est éliminé sélectivement par rapport au matériau de recouvrement 3 pour former les espaceurs latéraux. Enfin, le matériau de recouvrement 3 est éliminé sélectivement par rapport au matériau de masquage 5 pour reproduire le dessin du troisième masque de gravure 8.

Ce mode de réalisation particulier est extrêmement avantageux car chaque étape de gravure est réalisée avec un nombre restreint de matériaux. A la surface du substrat, ne sont présents que le matériau à éliminer et le matériau à conserver. Il n'y a pas, comme dans l'art antérieur, un matériau à éliminer en présence de deux matériaux à conserver. Il en ressort une plus grande liberté de choix dans les procédés utilisables pour réaliser la gravure et/ou des procédés de gravure plus robustes.

De manière avantageuse, dans la zone mince et la zone épaisse de la couche de recouvrement 3, le premier masque de gravure 4 est recouvert par le matériau de recouvrement 3. Le recouvrement intégral du premier masque de gravure 4 par le matériau de recouvrement permet de limiter le nombre de matériau visible lors de l'étape de gravure et ainsi faciliter la mise au point d'une chimie de gravure.

Dans un mode de réalisation préférentiel, le premier masque de gravure 4 est obtenu directement au moyen d'une étape de photolithograhie suivie d'une étape de gravure. Le dessin du premier masque de gravure 4 vient directement du dessin d'un masque en résine. Cette définition directe depuis le dessin défini par photolithographie permet de former facilement des zones de tailles différentes, avantageusement des zones ayant de dimensions nettement supérieures à celles définies dans le troisième masque de gravure 8 par les espaceurs. Dans ce mode de réalisation, un motif d'alignement de grande taille est formé, par exemple, au moins quelques microns dans le premier masque de gravure 4. Ce motif de grande taille permet un alignement facilité du niveau photolithographie du deuxième masque de gravure 6 par rapport à celui qui a défini le premier masque de gravure 4. Dans l'art antérieur, les niveaux photolithographiques sont inversés, le masque de gravure obtenu par transfert des espaceurs latéraux est formé avant le masque de gravure obtenu par photolithographie. Cet agencement des étapes de lithographie oblige à réaliser un alignement plus difficile au moyen de zones avec des densités importantes de motifs de petite taille. Ce procédé permet donc d'obtenir un meilleur alignement des deux niveaux photolithographiques utilisée et/ou un procédé d'alignement plus robuste.

A titre d'exemple illustré à la figure 18, le premier masque de gravure 4 est formé de manière classique. Le substrat 1 est muni de la couche en premier matériau 2 recouverte par une couche de masquage additionnelle 9 et un masque de gravure additionnel 10. Une couche de recouvrement additionnelle (non représentée) peut être utilisée pour réduire l'influence du substrat 1 lors de la formation du masque de gravure additionnel 10. La couche de recouvrement additionnelle et la couche de masquage additionnelle 9 sont gravées et la couche de masquage 9 forme le premier masque de gravure 4. Le masque de gravure additionnel 10 et la couche de recouvrement additionnelle sont éliminés pour ne laisser à la surface que le premier masque de gravure 4.

Dans d'autres modes de réalisation, le premier masque de gravure 4 peut être obtenu indirectement depuis le dessin du niveau photolithographie utilisé, par exemple en utilisant le transfert par espaceurs latéraux.

Il est également possible de réaliser des masques de gravure additionnels obtenus par le transfert d'espaceurs latéraux après la gravure du matériau de recouvrement 3 au moyen du troisième masque de gravure 8. Le procédé est alors identique à celui décrit précédemment en considérant que ce qui est présent sur le premier matériau 2 est le premier masque de gravure 4.

Lorsque le deuxième masque de gravure 6 est formé par photolithographie sur le matériau de recouvrement 3 cela impose certaines contraintes, notamment, dans le choix du matériau de recouvrement 3 et dans l'épaisseur utilisable. Ces contraintes ont pour but de faciliter l'étape de photolithographie en réduisant les problèmes de réflectivité et l'influence optique des couches inférieures. Ces contraintes ont pour effet d'accroître l'épaisseur de la couche de recouvrement 3 afin de faciliter la formation du second masque de gravure 4. Comme cela est indiqué plus haut, la couche de recouvrement 3 doit également permettre la définition des espaceurs latéraux ce qui limite la gamme de matériaux accessibles et/ou des gammes d'épaisseur utilisables pour obtenir un procédé qui soit conforme avec le relief imposé.

La gravure du matériau de recouvrement 3 sur une partie de son épaisseur permet de libérer au moins partiellement ces contraintes. L'étape de photolithographie est réalisée sur une certaine épaisseur de matériau de recouvrement 3. Cette épaisseur est choisie afin de faciliter l'étape de photolithographie. La couche en matériau de recouvrement 3 est ensuite gravée pour former une zone épaisse et une zone mince et cette différence d'épaisseur est utilisée pour faciliter la définition des espaceurs latéraux avec le rapport dimensionnel choisi. La définition des espaceurs est facilitée car un plus grand choix de matériaux est accessible, les difficultés à obtenir un dépôt conforme étant en partie gommées par la souplesse dans le choix de la différence d'épaisseur entre la zone mince et la zone épaisse.

## Revendications

1. Procédé de réalisation d'un motif en premier matériau (2) **caractérisé en ce qu'**il comporte les étapes suivantes :
- prévoir un substrat (1) muni d'une couche en premier matériau (2) recouverte par un premier masque de gravure (4), une couche de recouvrement (3) débordant le premier masque de gravure, et un deuxième masque de gravure (6), la couche de recouvrement (3) ayant une zone principale (C) recouverte par le deuxième masque de gravure (6) et une zone secondaire (D) découverte,
- graver partiellement la zone secondaire (D) de la couche de recouvrement (3) au moyen du deuxième masque de gravure (6) de manière à former un motif en saillie dans la couche de recouvrement (3),
- former et graver un matériau de masquage (5) de manière à former des espaceurs latéraux autour du motif en saillie définissant un troisième masque de gravure (8),
- éliminer le deuxième masque de gravure (6),
- graver la couche de recouvrement (3) au moyen du troisième masque de gravure (8) de manière à former un motif en saillie dans la couche de recouvrement (3) et découvrir le premier masque de gravure (4) et le premier matériau (2),
- graver la couche en premier matériau (2) au moyen de la couche de recouvrement (3) et du premier masque de gravure (4) pour former le motif en premier matériau (2).

2. Procédé selon la revendication 1, **caractérisé en ce que** la formation du premier masque de gravure (4) comporte les étapes suivantes :
- prévoir le substrat (1) muni de la couche en premier matériau (2) recouverte par une couche de masquage additionnelle (9), et un masque de gravure additionnel (10),
- graver la couche de masquage additionnelle (9), pour former le premier masque de gravure (4),
- éliminer le masque de gravure additionnel (10).

3. Procédé selon l'une des revendications 1 et 2, **caractérisé en ce que** le deuxième masque de gravure (6) est éliminé avant la formation des espaceurs latéraux autour du motif en saillie définissant un troisième masque de gravure (8).

4. Procédé selon l'une quelconque des revendications 1 à 3, **caractérisé en ce que** la couche de recouvrement (3) recouvre complètement le premier masque de gravure (4).

## Patentansprüche

1. Verfahren zur Herstellung eines Musters aus erstem Material (2), **dadurch gekennzeichnet, dass** es die folgenden Schritte umfasst:
- Vorsehen eines Substrats (1), das mit einer Schicht aus erstem Material (2) versehen ist, die mit einer ersten Ätzmaske (4), einer Deckschicht (3), welche über die erste Ätzmaske hinausragt, und einer zweiten Ätzmaske (6) überzogen ist, wobei die Deckschicht (3) einen mit der zweiten Ätzmaske (6) überzogenen Hauptbereich (C) und einen unbedeckten Nebenbereich (D) aufweist,
- teilweises Ätzen des Nebenbereichs (D) der Deckschicht (3) mittels der zweiten Ätzmaske (6), um ein vorspringendes Muster in der Deckschicht (3) auszubilden,
- Bilden und Ätzen eines Maskierungsmaterials (5), um seitliche Abstandshalter um das vorspringende Muster herum auszubilden, die eine dritte Ätzmaske (8) definieren,
- Entfernen der zweiten Ätzmaske (6),
- Ätzen der Deckschicht (3) mittels der dritten Ätzmaske (8), um ein vorspringendes Muster in der Deckschicht (3) auszubilden und die erste Ätzmaske (4) und das erste Material (2) freizulegen,
- Ätzen der Schicht aus erstem Material (2) mittels der Deckschicht (3) und der ersten Ätzmaske (4), um das Muster aus erstem Material (2) zu bilden.

2. Verfahren nach Anspruch 1, **dadurch gekennzeichnet, dass** die Bildung der ersten Ätzmaske (4) die folgenden Schritte umfasst:
- Vorsehen des Substrats (1), das mit der Schicht aus erstem Material (2) versehen ist, die mit einer zusätzlichen Maskierungsschicht (9) und einer zusätzlichen Ätzmaske (10) überzogen ist,
- Ätzen der zusätzlichen Maskierungsschicht (9), um die erste Ätzmaske (4) zu bilden,
- Entfernen der zusätzlichen Ätzmaske (10).

3. Verfahren nach einem der Ansprüche 1 und 2, **dadurch gekennzeichnet, dass** die zweite Ätzmaske (6) vor der Bildung der seitlichen Abstandshalter um das vorspringende Muster herum, die eine dritte Ätzmaske (8) definieren, entfernt wird.

4. Verfahren nach einem der Anspruche 1 bis 3, dadurch gekennzeichet, dass die Deckschicht (3) die erste Ätzmaske (4) vollständig bedeckt.

## Claims

1. A method for producing a pattern made from a first material (2) **characterized in that** it comprises the following steps:
- providing a substrate (1) provided with a layer of first material (2) covered by a first etching mask (4), a covering layer (3) extending over the first etching mask and a second etching mask (6), the covering layer (3) having a main area (C) covered by the second etching mask (6) and an uncovered secondary area (D),
- partially etching the secondary area (D) of the covering layer (3) by means of the second etching mask (6) so as to form a salient pattern in the covering layer (3),
- forming and etching a masking material (5) so as to form lateral spacers around the salient pattern defining a third etching mask (8),
- eliminating the second etching mask (6),
- etching the covering layer (3) by means of the third etching mask (8) so as to form a salient pattern in the covering layer (3) and to uncover the first etching mask (4) and the first material (2),
- etching the layer of first material (2) by means of the covering layer (3) and of the first etching mask (4) to form the pattern made from the first material (2).

2. The method according to claim 1, **characterized in that** formation of the first etching mask (4) comprises the following steps:
- providing the substrate (1) provided with the layer of first material (2) covered by an additional masking layer (9) and an additional etching mask (10),
- etching the additional masking layer (9) to form the first etching mask (4),
- eliminating the additional etching mask (10).

3. The method according to one of claims 1 and 2, **characterized in that** the second etching mask (6) is eliminated before the lateral spacers are formed around the salient pattern defining a third etching mask (8).

4. The method according to any one of claims 1 to 3, **characterized in that** the covering layer (3) completely covers the first etching mask (4).
